# EUROPÄISCHE PATENTSCHRIFT

(11) **EP 3 544 857 B1**
(45) Veröffentlichungstag und Bekanntmachung des Hinweises auf die Patenterteilung: **17.06.2020**
(21) Anmeldenummer: 17804439.2
(22) Anmeldetag: 23.11.2017
(51) Int. Cl.: B60R 11/02, B60R 21/015, B60R 22/48

(54) **VORRICHTUNG ZUM ERKENNEN EINES BESTIMMUNGSGEMÄSSEN ANLEGESTATUS EINES SICHERHEITSGURTS**
DEVICE FOR IDENTIFYING A PROPER BELT USAGE STATUS OF A SEAT BELT
DISPOSITIF PERMETTANT DE DÉTECTER UN ÉTAT DE MISE EN PLACE CORRECT D'UNE CEINTURE DE SÉCURITÉ

(30) Priorität: 25.11.2016 DE 102016122806
(43) Veröffentlichungstag der Anmeldung: 02.10.2019
(73) Patentinhaber: Audi AG, 85045 Ingolstadt (DE)
(72) Erfinder: Kunth, Katharina, 85057 Ingolstadt (DE); Michalke, Wolfgang, 85051 Ingolstadt (DE); Stadick, Patricia, 80807 München (DE); Scheef, Joachim, 85114 Buxheim (DE); Turnwald, Maximilian, 85049 Ingolstadt (DE); Ewald, Christian, 85051 Ingolstadt (DE)
(86) Internationale Anmeldenummer: PCT/EP2017/001365
(87) Internationale Veröffentlichungsnummer: WO 2018/095569

(56) Entgegenhaltungen:
- WO-A1-00/44595
- WO-A1-2015/191967
- DE-A1- 4 338 285
- JP-A- S63 159 158
- US-A- 4 885 566
- US-A1- 2015 265 200

## Beschreibung

Die Erfindung betrifft eine Vorrichtung zum Erkennen eines bestimmungsgemäßen Anlegestatus eines Sicherheitsgurts einer Sicherheitsgurtvorrichtung in einem Kraftfahrzeug.

Es ist allgemein bekannt, dass ein Insasse in einem Fahrzeug, insbesondere Kraftfahrzeug, bei einer ordnungsgemäßen Benutzung einer Sicherheitsgurtvorrichtung im Falle eines Unfalls einem besonders geringen Verletzungsrisiko ausgesetzt ist. Um sicherzustellen, dass möglichst jeder Insasse des Kraftfahrzeugs die Sicherheitsgurtvorrichtung ordnungsgemäß benutzt, sind in modernen Kraftfahrzeugen Vorrichtungen eingesetzt, welche überwachen sollen, ob ein Insasse des Kraftfahrzeugs die Sicherheitsgurtvorrichtung ordnungsgemäß nutzt. Dennoch hebeln manche Insassen des Kraftfahrzeugs derartige Vorrichtungen, teils aus Gründen der Bequemlichkeit und teils aus anderen Gründen, aus, um die Sicherheitsgurtvorrichtung nicht zu nutzen. Daher sind Vorrichtungen zu entwickeln, die zuverlässig in der Lage sind, festzustellen, ob eine Sicherheitsgurtvorrichtung von dem jeweiligen Insassen ordnungsgemäß genutzt wird.

Aus dem Stand der Technik, insbesondere aus dem Serienfahrzeugbau, sind Überwachungs- und/oder Kontrolleinrichtungen, die eine ordnungsgemäße Nutzung einer Sicherheitsgurtvorrichtung ermitteln, bereits hinlänglich bekannt. Beispielsweise offenbart das Dokument US 4 885 566 eine Sicherheitsgurtvorrichtung mit einer Gurtelektrode und einer Sitzelektrode, zwischen welchen ein elektrisches Feld aufgebaut ist, welches durch zumindest einen Teil eines Sitzinsassen verläuft. Weiter ist eine Kapazitätsmesseinheit vorhanden, welche die von der Gurtelektrode und der Sitzelektrode gebildete Kapazität erfasst. Die Kapazitätsmesseinheit ist mit einer Überwachungseinheit verbunden, welche anhand einer besonders niedrigen beziehungsweise besonders hohen Kapazität feststellt, ob ein Gurt nicht über beziehungsweise über einen Sitzinsassen verläuft.

Hierbei besteht der Nachteil, dass in dem Fahrzeugsitz ein weiteres elektrisches Bauteil eingesetzt ist. Aus dem Stand der Technik ist eine Vielzahl von Dokumenten bekannt, die ein optisches Erkennen nutzen. So zeigt das Dokument DE 101 42 792 A1 ein bildverarbeitendes System zur Erkennung, ob ein Sicherheitsgurt bestimmungsgemäß von einem Sitzinsassen angewendet ist.

Nachteilig hierbei ist, dass ein Kleidungsstück, welches von dem Sitzinsassen getragen wird, ein Muster aufweisen kann, welches von dem bildverarbeitenden System mit dem Sicherheitsgurt verwechselt werden kann.

Die US 2015/265200 A1, die dem Oberbegriff der Ansprüche 1 und 9 entspricht, offenbart Sicherheitsgurtanordnungen und Verfahren zum Bestimmen einer Information bezüglich der Herz- und/oder Atemaktivität eines Benutzers eines Sicherheitsgurtes. Es kommen hierbei zumindest zwei Mikrofone zum Einsatz, wobei von einem ersten Mikrofon erzeugte Signale unter Verwendung von mit einem zweiten Mikrofon erfassten Umgebungsgeräuschen korrigiert werden.

Aufgabe der vorliegenden Erfindung ist es daher, möglichst zuverlässig eine ordnungsgemäße Nutzung einer Sicherheitsgurtvorrichtung in einem Kraftfahrzeug zu erkennen. Diese Aufgabe wird erfindungsgemäß durch eine Vorrichtung und ein Verfahren mit den Merkmalen der unabhängigen Patentansprüche gelöst. Vorteilhafte Ausgestaltungen mit zweckmäßigen Weiterbildungen der Erfindung sind in den übrigen Patentansprüchen angegeben.

Erfindungsgemäß ist eine Vorrichtung zum Erkennen eines bestimmungsgemäßen Anlegestatus eines Sicherheitsgurts einer Sicherheitsgurtvorrichtung in einem Kraftfahrzeug vorgesehen, welche eine zumindest teilweise in oder an dem Sicherheitsgurt angeordnete Sensoreinrichtung umfasst, welche dazu ausgelegt ist, wenigstens einen Sensorwert auszugeben, welcher eine Abhängigkeit von der Anordnung des Sicherheitsgurts aufweist, und eine Auswerteeinrichtung, welche dazu eingerichtet ist, basierend auf dem mittels der Sensoreinrichtung ausgegebenen Sensorwert zu ermitteln, ob ein Insasse des Kraftfahrzeugs den Sicherheitsgurt bestimmungsgemäß angelegt hat.

Die Sicherheitsgurtvorrichtung umfasst neben dem Sicherheitsgurt, welcher heutzutage üblicherweise als Dreipunktgurt mit einer Aufrollautomatik ausgeführt ist, eine Vielzahl an weiteren Systemen, zum Beispiel einen elektrischen Gurtstrammer, einen pyrotechnischen Gurtstraffer oder eine Einrichtung zum Verringern von Gurtlosen. Dem Sicherheitsgurt sind zumindest ein teilweise auf einer Trommel der Aufrollautomatik aufgerolltes Sicherheitsgurtband, ein unterer äußerer Befestigungspunkt, ein oberer äußerer Befestigungspunkt und ein innerer Befestigungspunkt zugeordnet. Der innere Befestigungspunkt ist üblicherweise fahrzeugseitig als ein Gurtschloss ausgebildet, das dazu eingerichtet ist, eine an dem Sicherheitsgurtband angeordnete Gurtschlosszunge aufzunehmen. Der Sicherheitsgurt ist bestimmungsgemäß angelegt, das heißt, es ist ein bestimmungsgemäßer Anlegestatus des Sicherheitsgurts realisiert, wenn der Insasse in dem Fahrzeug in einem Fahrzeugsitz sitzt, das Sicherheitsgurtband an einer vorderen Körperseite des Insassen über den Insassen verläuft und die Gurtschlosszunge in dem Gurtschloss verriegelt ist. Ein Anteil des Sicherheitsgurtbands, das bei einem bestimmungsgemäßen Anlegestatus zwischen dem oberen äußeren Befestigungspunkt und dem inneren Befestigungspunkt verläuft, wird als Brustgurt bezeichnet und ein weiterer Anteil des Sicherheitsgurtbands, das bei einem bestimmungsgemäßen Anlegestatus zwischen dem inneren Befestigungspunkt und dem unteren äußeren Befestigungspunkt verläuft, wird als Beckengurt bezeichnet.

Die zumindest teilweise in oder an dem Sicherheitsgurt angeordnete Sensoreinrichtung kann beispielsweise als ein Schalter ausgebildet sein, welcher in dem Gurtschloss angeordnet ist. Je nachdem, ob die Gurtschlosszunge in dem Gurtschloss verriegelt ist oder nicht, ist ein Stromkreis, in welchem der Schalter angeordnet ist, geschlossen oder unterbrochen. Der Schalter gibt also einen Sensorwert aus, der eine Abhängigkeit von der Anordnung des Sicherheitsgurts aufweist und von der Auswerteeinrichtung ausgewertet werden kann. Die Auswerteeinrichtung kann zum Beispiel als eine Elektronikeinheit ausgebildet sein, welche in der Lage ist, ein Warnsignal auszugeben, wenn der Stromkreis unterbrochen, das heißt die Gurtschlosszunge nicht in dem Gurtschloss verriegelt ist.

Die Sensoreinrichtung umfasst zumindest ein an dem Sicherheitsgurt angeordnetes Mikrofon, welches dazu ausgelegt ist, ein mit zumindest einem erfassten Schallsignal korrespondierendes Mikrofonsignal auszugeben, wobei die Auswerteeinrichtung dazu eingerichtet ist, anhand des Mikrofonsignals zu ermitteln, ob der Insasse den Sicherheitsgurt bestimmungsgemäß angelegt hat. Das an dem Sicherheitsgurt, insbesondere an dem Sicherheitsgurtband, angeordnete Mikrofon kann beispielsweise als ein Gurtmikrofon ausgebildet sein, welches beispielsweise zu einer fahrzeugseitigen Freisprecheinrichtung gehört. Das Mikrofon ist dazu eingerichtet, zumindest ein in der Umgebung des Mikrofons erzeugtes Schallsignal aufzunehmen, und ein zu dem Schallsignal korrespondierendes Mikrofonsignal auszugeben. Dadurch dass das Mikrofon mit der Auswerteeinrichtung verbunden ist, ist die Auswerteeinrichtung in der Lage, anhand von Charakteristika des Mikrofonsignals zu ermitteln, ob der Insasse in dem Kraftfahrzeug den Sicherheitsgurt bestimmungsgemäß angelegt hat. Diese Ausführungsform bietet den Vorteil, dass das an dem Sicherheitsgurt angeordnete Gurtmikrofon eine Doppelfunktionalität innehat, wodurch die Vorrichtung besonders kosteneffizient zu realisieren ist.

Wenigstens ein Lautsprecher des Kraftfahrzeugs erzeugt das Schallsignal. Hierbei kann der Lautsprecher beispielsweise Teil eines Infotainment-Systems des Kraftfahrzeugs sein. Alternativ oder zusätzlich kann der Lautsprecher auch als ein separater, der Vorrichtung zugeordneter Lautsprecher ausgebildet sein. Das Schallsignal kann als ein Ton ausgebildet sein oder als ein Tongemisch, welches mindestens zwei Töne unterschiedlicher Frequenz umfasst. Dadurch, dass ein Lautsprecher des Kraftfahrzeugs eingesetzt wird, um das Schallsignal zu erzeugen, ergibt sich eine Vielzahl von Möglichkeiten, um das Erkennen des korrekten Anlegestatus des Sicherheitsgurts mittels der Vorrichtung besonders zuverlässig zu realisieren.

Hierdurch ist eine Vorrichtung bereitgestellt, welche eine ordnungsgemäße Nutzung einer Sicherheitsgurtvorrichtung in einem Kraftfahrzeug zuverlässig erkennt.

In einer weiteren Ausführungsform gemäß der Erfindung umfasst die Sensoreinrichtung einen Kondensator mit zwei Elektroden, wobei die eine Elektrode in oder an dem Sicherheitsgurt angeordnet und die andere Elektrode in Form einer Heizdrahtanordnung einer Sitzheizung ausgebildet ist, wobei die Auswerteeinrichtung dazu eingerichtet ist, anhand eines am Kondensator gemessenen Zustandswerts zu ermitteln, ob der Insasse den Sicherheitsgurt bestimmungsgemäß angelegt hat. Anders ausgedrückt, können an und/oder in dem Sicherheitsgurtband elektrisch leitende Elemente angeordnet sein, welche die eine Elektrode des Kondensators bilden. Beispielsweise kann in einem Gewebe des Sicherheitsgurtbands eine Vielzahl von miteinander in Kontakt stehenden metallischen Fasern eingewebt sein oder auf das Gewebe des Sicherheitsgurtbands kann eine metallische Beschichtung aufgebracht sein. Eine derartige gurtseitige Elektrode kann jeweils an dem Beckengurt und/oder dem Brustgurt angeordnet sein. Die andere Elektrode des Kondensators ist in einem Fahrzeugsitz angeordnet und wird von der Sitzheizungsmatte gebildet. Eine derartige Sitzheizungsmatte kann jeweils in einem Sitzkissen des Fahrzeugsitzes und/oder in einer Rückenlehne des Fahrzeugsitzes angeordnet sein. Die gurtseitigen Elektroden sind jeweils einer sitzseitigen Elektrode zugeordnet, d. h. die Gurtelektrode des Brustgurts ist der Elektrode bzw. Sitzheizungsmatte in der Rückenlehne des Fahrzeugsitzes zugeordnet und die Gurtelektrode des Beckengurts ist der Elektrode bzw. Sitzheizungsmatte des Sitzkissens des Fahrzeugsitzes zugeordnet. Ferner sind die Elektroden jeweils mit der Auswerteeinheit verbunden, sodass die Auswerteeinheit in der Lage ist, eine Kapazität des Kondensators zu ermitteln. Die Kapazität des Kondensators ist abhängig von einem Material zwischen der am Sicherheitsgurtband angeordneten Elektrode und der im Fahrzeugsitz angeordneten Elektrode. Das heißt, die Kapazität nimmt einen ersten Wert an, wenn das Sicherheitsgurtband nicht ordnungsgemäß, das heißt bestimmungsgemäß genutzt ist. Beispielsweise kann die Gurtschlosszunge in dem Gurtschloss verriegelt worden sein, wobei kein Insasse in dem Fahrzeugsitz gesessen hat. Es ist also in diesem Fall Luft zwischen den jeweiligen einander zugeordneten Elektroden angeordnet. Die Kapazität nimmt einen von dem ersten Wert unterschiedlichen zweiten Wert an, wenn das Sicherheitsgurtband ordnungsgemäß, das heißt bestimmungsgemäß genutzt ist. Dies bedeutet, dass der Insasse zwischen der an dem Sicherheitsgurt angeordneten Elektrode und der in dem Fahrzeugsitz angeordneten Elektrode angeordnet ist, wobei die Gurtschlosszunge in dem Gurtschloss verriegelt ist. Die Auswerteeinrichtung kann beispielsweise eine Kapazitätsmesseinrichtung umfassen, sodass die Auswerteeinrichtung in der Lage ist, eindeutig und zuverlässig zu ermitteln, ob der in dem Fahrzeugsitz sitzende Insasse den Sicherheitsgurt bestimmungsgemäß angelegt hat, das bedeutet, zu ermitteln, ob das Sicherheitsgurtband auf einer vorderen Seite des Körpers des Insassen verläuft, oder zwischen dem Fahrzeugsitz und dem Insassen.

Vorteilhaft hierbei ist, dass die Sitzheizungsmatte in dem Kraftfahrzeug eine Doppelfunktionalität aufweist, indem durch die Sitzheizungsmatte eine Elektrode des Kondensators gebildet wird. Hierdurch lässt sich die Vorrichtung besonders kosteneffizient und ohne zusätzliche Arbeitsschritte herstellen.

Eine weitere Ausbildungsform der Erfindung sieht vor, dass das Schallsignal ein Umgebungsgeräusch und/oder ein Geräusch des Kraftfahrzeugs umfasst. Mit anderen Worten kann das Schallsignal durch das Kraftfahrzeug erzeugt werden. Beispielsweise kann ein Geräusch, welches von einem Motor des Kraftfahrzeugs erzeugt wird und in den Innenraum des Kraftfahrzeugs eindringt, das Schallsignal bilden. Außerdem kann das Schallsignal beispielsweise mittels eines Abrollgeräusches der Reifen des Kraftfahrzeugs während eines Fahrbetriebs erzeugt werden.

Bei dieser Ausgestaltung unterbleibt der Einsatz einer separaten Schallquelle, sodass die Vorrichtung besonders kosteneffizient realisiert werden kann.

Gemäß einer weiteren vorteilhaften Ausführungsform der Erfindung ist es vorgesehen, dass die Auswerteeinrichtung dazu eingerichtet ist, anhand einer Messung der Laufzeit des Schallsignals von dem Lautsprecher zu dem Mikrofon zu ermitteln, ob der Insasse den Sicherheitsgurt bestimmungsgemäß angelegt hat. Mit anderen Worten wird mittels des Lautsprechers das Schallsignal zu einem ersten Zeitpunkt erzeugt. Das Schallsignal bewegt sich in Form von zumindest einer Welle durch die Luft und unter anderem in Richtung zu dem Mikrofon hin, wobei die Welle des Schallsignals zu einem von dem ersten Zeitpunkt unterschiedlichen zweiten Zeitpunkt auf das Gurtmikrofon auftrifft. Es vergeht also zwischen dem ersten Zeitpunkt (Erzeugen des Schallsignals) bis zu dem zweiten Zeitpunkt (Empfangen des Schallsignals von dem Mikrofon) eine Dauer, welche als Laufzeit des Schallsignals bezeichnet wird. Anhand dieser Laufzeit kann die Auswerteeinrichtung ermitteln, in welcher Entfernung von dem Lautsprecher das Mikrofon beziehungsweise Gurtmikrofon zum zweiten Zeitpunkt angeordnet ist. Somit kann die Auswerteeinrichtung feststellen, ob sich das Mikrofon, das heißt das Sicherheitsgurtband, ausreichend nahe an dem Lautsprecher befindet, um von dem Insassen des Fahrzeugs bestimmungsgemäß angelegt zu sein. Wird durch die Auswerteeinrichtung festgestellt, dass das Mikrofon, also das Sicherheitsgurtband, in einer zu großen Entfernung zu dem Lautsprecher angeordnet ist, hat der Insasse den Sicherheitsgurt offensichtlich nicht bestimmungsgemäß angelegt.

Bei dieser vorteilhaften Ausführungsform kann also die Lage eines Sicherheitsgurts in einem Kraftfahrzeug besonders genau ermittelt werden.

In einer weiteren Ausführungsform der vorliegenden Erfindung ist es vorgesehen, dass der Lautsprecher derart gesteuert wird, dass das Schallsignal zyklisch ausgesendet wird. Das zyklische, das heißt zeitlich wiederkehrende Aussenden des Schallsignals von dem Lautsprecher bietet den Vorteil, dass der korrekte Anlegestatus des Sicherheitsgurts über den Insassen zeitlich wiederkehrend kontrolliert werden kann. Dies bedeutet, dass überprüft werden kann, ob der Insasse den Sicherheitsgurt bestimmungsgemäß angelegt hat und ob der Insasse den bestimmungsgemäßen Anlegestatus des Sicherheitsgurts verändert, z. B. das Gurtschloss entriegelt und den Sicherheitsgurt nicht weiter nutzt. Somit kann die Vorrichtung nicht umgangen werden, zum Beispiel indem der Insasse sich zu Beginn einer Fahrt mit dem Kraftfahrzeug ordnungsgemäß angurtet und nach einer gewissen Zeit, zum Beispiel nachdem die erste Überprüfung des Anlegestatus stattgefunden hat, den Sicherheitsgurt wieder ablegt.

Ferner hat es sich als vorteilhaft gezeigt, dass das Schallsignal als ein Ultraschallsignal ausgebildet ist. Besonders in diesem Fall ist es möglich, dass der das Schallsignal erzeugende Lautsprecher Teil einer Innenraumüberwachungseinrichtung einer Diebstahlwarnanlage des Kraftfahrzeugs ist. Dadurch, dass das menschliche Gehör nicht in der Lage ist, Schall im Ultraschallbereich wahrzunehmen, ist insbesondere bei einer zyklischen Überwachung des Gurtanlegestatus ein besonders hoher Komfort gewahrt. Ferner ist bei der Verwendung des Lautsprechers der Diebstahlwarnanlage kein separater Lautsprecher vorzusehen, wodurch die Vorrichtung besonders kosteneffizient realisiert werden kann.

Eine weitere Ausbildungsform der Erfindung sieht vor, dass die Auswerteeinrichtung dazu eingerichtet ist, anhand zumindest einer Veränderung einer das Schallsignal charakterisierenden Größe zu ermitteln, ob der Insasse den Sicherheitsgurt bestimmungsgemäß angelegt hat. Mit anderen Worten wird durch die Auswerteeinrichtung festgestellt, ob zum Beispiel eine Amplitude des Schallsignals während einer bestimmten Zeit, zum Beispiel der Laufzeit, eine Dämpfung erfahren hat. Wird das Schallsignal in Form eines Tongemisches von dem Lautsprecher ausgesendet, kann die Auswerteeinrichtung ermitteln, ob z. B. nur noch niederfrequente Anteile des Tongemisches an dem Mikrofon ankommen, also eine Schallbeugung erfolgt ist. Eine Dämpfung und/oder eine Schallbeugung treten im Allgemeinen auf, wenn sich zwischen der Schallquelle, also dem Lautsprecher, und dem Schallempfänger, also dem Mikrofon, Hindernisse, insbesondere Schallhindernisse, befinden. Dadurch ist die Auswerteeinrichtung in der Lage, festzustellen, ob ein Insasse auf den bereits zuvor geschlossenen Gurt sitzt, um die Vorrichtung zu umgehen. Hierbei kann der Insasse das Schallhindernis bilden, indem der Oberkörper des Insassen das Gurtmikrofon zumindest teilweise verdeckt.

Mit dieser Ausführungsform ist ein besonders zuverlässiges Erkennen eines bestimmungsgemäßen Anlegestatus mittels der Vorrichtung gewährleistet.

Die vorliegende Erfindung sieht weiter ein Kraftfahrzeug mit einer Vorrichtung zum Erkennen eines bestimmungsgemäßen Anlegestatus eines Sicherheitsgurts einer Sicherheitsgurtvorrichtung vor. Dieses Kraftfahrzeug bietet einen besonders hohen Insassenschutz, da mittels der Vorrichtung eine ordnungsgemäße Nutzung der Sicherheitsgurtvorrichtung in dem Kraftfahrzeug zuverlässig erkannt wird.

Ferner sieht die vorliegende Erfindung ein Verfahren zum Erkennen eines bestimmungsgemäßen Anlegestatus eines Sicherheitsgurts einer Sicherheitsgurtvorrichtung in einem Kraftfahrzeug vor, mit den Schritten: Ausgeben zumindest eines von der Anordnung des Sicherheitsgurts abhängigen Sensorwerts mittels einer zumindest teilweise in oder an dem Sicherheitsgurt angeordneten Sensoreinrichtung, und Ermitteln mittels einer Auswerteeinrichtung basierend auf dem ausgegebenen Sensorwert, ob ein Insasse des Kraftfahrzeugs den Sicherheitsgurt bestimmungsgemäß angelegt hat. Es ist vorgesehen, dass die Sensoreinrichtung zumindest ein an dem Sicherheitsgurt angeordnetes Mikrofon umfasst, mittels dessen ein mit zumindest einem erfassten Schallsignal korrespondierendes Mikrofonsignal ausgegeben wird, wobei mittels der Auswerteeinrichtung anhand des Mikrofonsignals ermittelt wird, ob der Insasse den Sicherheitsgurt bestimmungsgemäß angelegt hat, wobei wenigstens ein Lautsprecher des Kraftfahrzeugs das Schallsignal erzeugt.

Vorteilhafte Ausgestaltungen der erfindungsgemäßen Vorrichtung sind als vorteilhafte Ausgestaltungen des erfindungsgemäßen Verfahrens anzusehen, wobei das Verfahren insbesondere Verfahrensschritte umfasst, welche mittels der Vorrichtung ausgeführt werden.

Weitere Vorteile, Merkmale und Einzelheiten der Erfindung ergeben sich aus der nachfolgenden Beschreibung bevorzugter Ausführungsbeispiele sowie anhand der Zeichnung. Die vorstehend in der Beschreibung genannten Merkmale und Merkmalskombinationen sowie die nachfolgend in der Figurenbeschreibung genannten Merkmale und Merkmalskombinationen sind dabei nicht nur in Alleinstellung sondern auch in Kombination untereinander verwendbar, ohne den Rahmen der Erfindung zu verlassen.

Die Zeichnung zeigt in
- Fig. 1: in einer schematischen Ansicht eine Vorrichtung zum Erkennen eines bestimmungsgemäßen Anlegestatus eines Sicherheitsgurts einer Sicherheitsgurtvorrichtung in einem Kraftfahrzeug;
- Fig. 2: in einer schematischen Ansicht die Vorrichtung, wobei ein Prinzip des kapazitiven Erkennens eingesetzt ist;
- Fig. 3: in einer schematischen Ansicht die Vorrichtung, wobei ein Prinzip des akustischen Erkennens eingesetzt ist;
- Fig. 4: in einer schematischen Ansicht die in Fig. 3 dargestellte Vorrichtung, wobei ein Lautsprecher eingesetzt ist;
- Fig. 5: in einer schematischen Ansicht ein Kraftfahrzeug mit einer Vorrichtung zum Erkennen eines bestimmungsgemäßen Anlegestatus eines Sicherheitsgurts einer Sicherheitsgurtvorrichtung; und
- Fig. 6: einen Ablaufplan von Schritten eines Verfahrens zum Erkennen eines bestimmungsgemäßen Anlegestatus eines Sicherheitsgurts einer Sicherheitsgurtvorrichtung in einem Kraftfahrzeug.

In den Figuren werden gleiche oder funktionsgleiche Elemente mit den gleichen Bezugszeichen versehen.

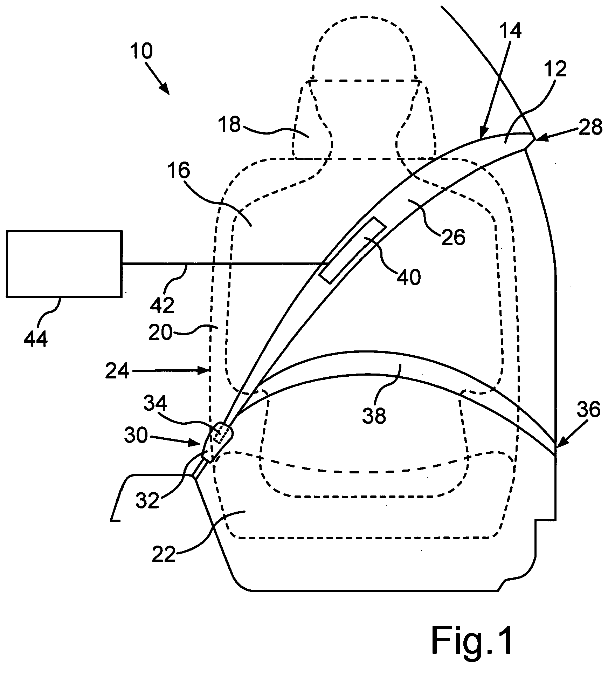

Die Vorrichtung 10 zum Erkennen eines bestimmungsgemäßen Anlegestatus eines Sicherheitsgurts 12 einer Sicherheitsgurtvorrichtung 14 in einem nicht dargestellten Kraftfahrzeug ist in Fig. 1 dargestellt. In Fig. 1 ist ferner ein Insasse 16 gezeigt, welcher auf dem eine Kopfstütze 18, eine Rückenlehne 20 und ein Sitzkissen 22 aufweisenden Fahrzeugsitz 24 sitzt. Der Sicherheitsgurt 12 bildet einen Brustgurt 26, welcher zwischen einem oberen äußeren Befestigungspunkt 28 und einem inneren Befestigungspunkt 30 verläuft. Der innere Befestigungspunkt 30 ist üblicherweise als ein Gurtschloss 32 ausgeführt, in welchem eine Gurtschlosszunge 34 angeordnet, zum Beispiel verriegelt, ist. Zwischen dem inneren Befestigungspunkt 30 und dem unteren äußeren Befestigungspunkt 36 verläuft ein als Beckengurt 38 bezeichneter Anteil des Sicherheitsgurts 12. Diese Anordnung des Sicherheitsgurts 12 entspricht einem so genannten Dreipunktgurt, wobei das Gurtschloss 32 eine nicht näher dargestellte Taste umfasst, mittels welcher der Insasse 16 die Gurtschlosszunge 34 aus dem Gurtschloss 32 entriegeln und entnehmen kann, sodass ein komfortables Aussteigen aus dem Fahrzeugsitz ermöglicht wird.

Ferner ist in Fig. 1 eine Sensoreinrichtung 40 dargestellt, welche zumindest teilweise in oder an dem Sicherheitsgurt angeordnet ist und mittels einer Übertragungseinheit 42, mit einer Auswerteeinheit 44 verbunden ist. Die Sensoreinrichtung 40 ist in der Lage, wenigstens einen Sensorwert auszugeben, welcher eine Abhängigkeit von einer Anordnung, das heißt Positionierung des Sicherheitsgurts, aufweist. Beispielsweise unterscheidet sich ein Sensorwert bei einem nicht geschlossenen Gurtschloss 32 - das heißt, der Insasse hat die Gurtschlosszunge 34 nicht in dem Gurtschloss 32 verriegelt - von einem weiteren Sensorwert bei einem geschlossenen Gurtschloss - das heißt bei einem von dem Insassen korrekt angelegten Sicherheitsgurt 12. Der Sensorwert wird über die Übertragungseinheit 42 der Auswerteeinrichtung 44 bereitgestellt. Die Auswerteeinrichtung 44 ist dazu eingerichtet, basierend auf dem ihr bereitgestellten Sensorwert zu ermitteln, ob ein Insasse des Kraftfahrzeugs den Sicherheitsgurt bestimmungsgemäß angelegt hat. Die Auswerteeinrichtung 44 kann beispielsweise Mittel umfassen, welche in der Lage sind, den Insassen 16 darauf aufmerksam zu machen, dass der Sicherheitsgurt 12 nicht bestimmungsgemäß angelegt ist. Hierzu können beispielsweise Warnsignale, zum Beispiel Warnleuchten und/oder Warntöne aktiviert werden und/oder verhindert werden, dass das Kraftfahrzeug losfährt.

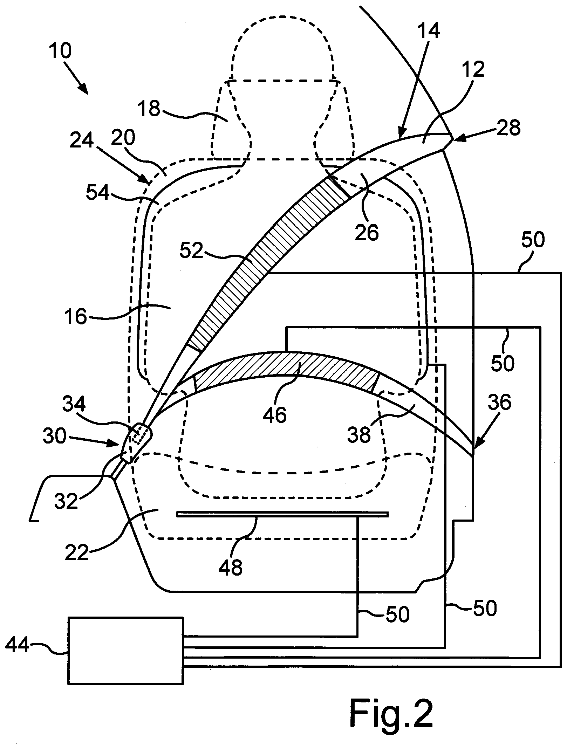

In Fig. 2 ist die Vorrichtung 10 dargestellt, wobei das Erkennen des bestimmungsgemäßen Anlegestatus des Sicherheitsgurts 12 mittels einer kapazitiven Erkennung erfolgen kann. Hierzu wird ein elektrischer Kondensator beziehungsweise eine einem elektrischen Kondensator ähnliche Vorrichtung in dem Kraftfahrzeug eingesetzt. Die erste Elektrode 46 ist beispielsweise an dem Beckengurt 38 angebracht. Die erste Elektrode 46 kann in dem Beckengurt 38 in Form von metallischen Fasern eingewebt und/oder in Form einer metallischen Beschichtung auf ein Gewebe des Gurtbands des Sicherheitsgurts 12 aufgebracht sein. Eine der ersten Elektrode 46 zugeordnete zweite Elektrode 48 ist in dem Fahrzeugsitz 24, insbesondere in dem Sitzkissen 22 des Fahrzeugsitzes 24, in Form einer Heizdrahtanordnung für eine Fahrzeugsitzheizung ausgebildet. Die Elektrode 46 und die Elektrode 48 liegen einander im Wesentlichen gegenüber und sind jeweils mittels der zum Beispiel als Kabel 50 ausgeführten Übertragungseinheit 42 mit der Auswerteeinrichtung 44 verbunden. Dadurch dass sich die beiden Elektroden 46 und 48 gegenüberliegen, bilden sie die kondensatorähnliche Anordnung, welche eine elektrische Kapazität aufweist. Die elektrische Kapazität, also der Sensorwert, hängt bei dieser Ausführungsform unter anderem davon ab, wie weit die beiden Elektroden 48 und 46 voneinander beabstandet sind und welches Material zwischen den beiden Elektroden 46 und 48 angeordnet ist. Das heißt also, dass anhand der mittels der Auswerteeinrichtung 44 gemessenen Kapazität der kondensatorähnlichen Anordnung festgestellt werden kann, ob der Beckengurt 38 bestimmungsgemäß über einen Unterkörper des Insassen 16 verläuft und nicht direkt auf der Fläche des Sitzkissens 22 zwischen dem Unterkörper des Insassen 16 und dem Sitzkissen 22. Wie in Fig. 2 ebenfalls dargestellt ist, kann alternativ oder zusätzlich eine weiteren kondensatorähnliche Anordnung in der Vorrichtung 10 eingesetzt sein, um auf kapazitivem Wege zu erkennen, ob ein Insasse 16 den Sicherheitsgurt 12 bestimmungsgemäß angelegt hat. Hierzu kann in und/oder an dem Brustgurt 26 eine weitere Elektrode 52 angeordnet sein. In der Rückenlehne 20 des Fahrzeugsitzes 24 kann eine weitere Sitzheizungsmatte beziehungsweise Elektrode 54 integriert sein, welche mit der zugeordneten Elektrode 52 eine weitere kondensatorähnliche Anordnung bildet. Die Sitzheizungsmatte beziehungsweise Elektrode 54 und die Elektrode 52 sind jeweils mittels eines Kabels 50 mit der Auswerteeinrichtung 44 verbunden. Indem die Auswerteeinrichtung 44 die elektrische Kapazität der durch die Elektrode 52 und 54 gebildeten kondensatorähnlichen Anordnung misst, kann festgestellt werden, ob der Sicherheitsgurt 12 auf dem Oberkörper des Insassen 16 und nicht auf dem Rücken des Insassen 16 zwischen dem Oberkörper des Insassen 16 und der Rückenlehne 20 des Fahrzeugsitzes 24 verläuft. Ein Messen der elektrischen Kapazität der kondensatorähnlichen Anordnungen der Vorrichtung 10 mittels der Auswerteeinrichtung 44 kann beispielsweise erfolgen, indem an die kondensatorähnliche Anordnung eine Wechselspannung angelegt wird und der Stromfluss gemessen wird. Da die elektrische Kapazität und der Stromfluss in einem Wechselstromkreis direkt proportional zueinander sind, kann mittels einfacher physikalischer Formeln die Kapazität der kondensatorähnlichen Anordnung ermittelt werden.

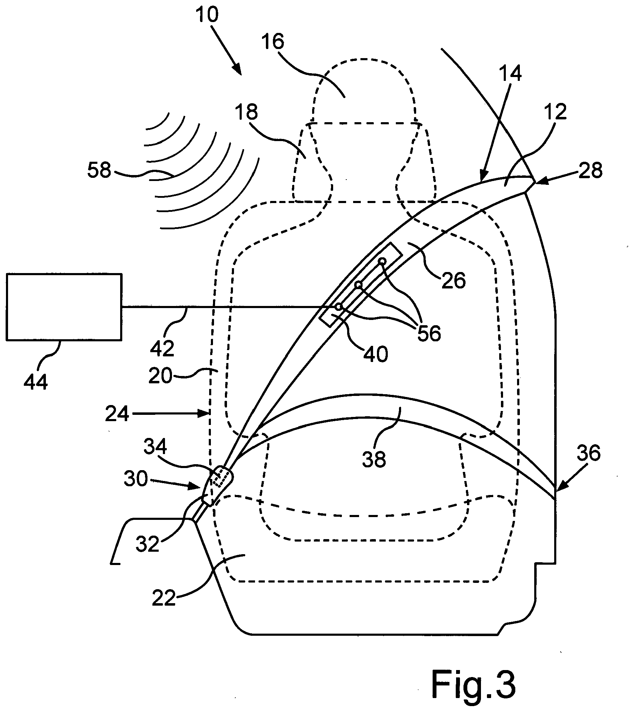

In Fig. 3 ist die Vorrichtung 10 gezeigt, bei welcher die Sensoreinrichtung 40 zumindest ein an dem Sicherheitsgurt angeordnetes Mikrofon beziehungsweise Gurtmikrofon 56 aufweisen kann. Das Gurtmikrofon 56 ist dazu eingerichtet, ein Schallsignal 58 zu erfassen und ein Mikrofonsignal auszugeben, welches mit dem Schallsignal 58 korrespondiert. Das Mikrofonsignal wird über die Übertragungseinheit 42 der Auswerteeinrichtung 44 bereitgestellt. Die Auswerteeinrichtung 44 ist eingerichtet, das Mikrofonsignal dahingehend auszuwerten, ob der Sicherheitsgurt 12 bestimmungsgemäß über dem Insassen 16 angeordnet ist. Dies bedeutet, dass, wenn der Sicherheitsgurt 12 bestimmungsgemäß über dem Insassen 16 angeordnet ist, aufgrund des Schallsignals 58 mittels des Gurtmikrofons 56 ein erstes Mikrofonsignal erzeugt wird, das sich von einem zweiten Mikrofonsignal unterscheidet, welches mittels des Gurtmikrofons 56 aufgrund des Schallsignals 58 erzeugt wurde, wenn der Sicherheitsgurt 12 von dem Insassen 16 falsch oder gar nicht genutzt ist.

Das Schallsignal 58 kann ein Umgebungsgeräusch und/oder ein Geräusch des Kraftfahrzeugs umfassen. Dies bedeutet, dass insbesondere während eines Fahrbetriebs des Kraftfahrzeugs Geräusche, welche beispielsweise durch einen Betrieb eines Motors des Kraftfahrzeugs und/oder von den auf der Straße abrollenden Reifen des Kraftfahrzeugs erzeugt werden, in einen Innenraum des Kraftfahrzeugs eindringen. Diese in den Innenraum des Kraftfahrzeugs eingedrungenen Geräusche können durch das Gurtmikrofon 56 erfasst und in das Mikrofonsignal umgewandelt werden. Wird mittels der Auswerteeinrichtung 44 festgestellt, dass die in den Innenraum des Kraftfahrzeugs eingedrungenen Geräusche als besonders leise einzustufen sind, stellt die Auswerteeinrichtung 44 fest, dass der Sicherheitsgurt 12 von dem Insassen 16 nicht ordnungsgemäß angelegt ist.

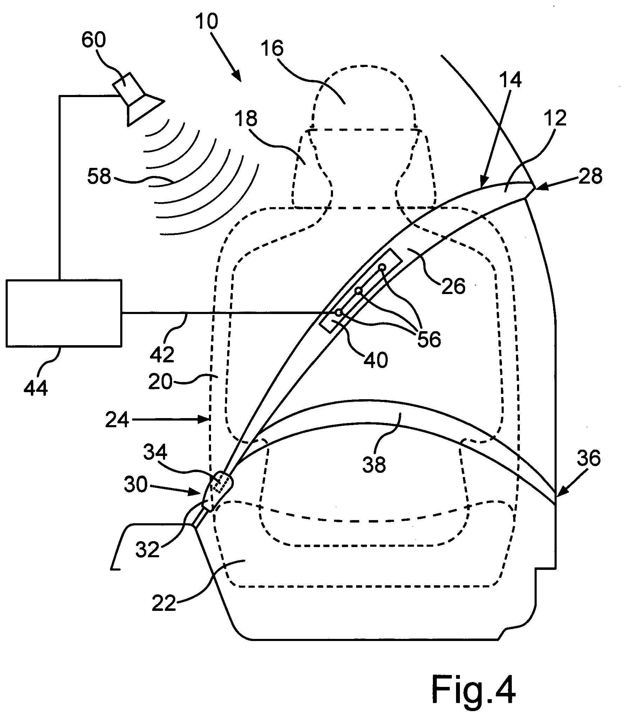

In Fig. 4 ist gezeigt, dass bei der Vorrichtung 10 das Schallsignal 58 durch wenigstens einen Lautsprecher 60 des Kraftfahrzeugs erzeugt werden kann. Dadurch, dass das Schallsignal 58 mittels des Lautsprechers 60 aktiv erzeugt wird, kann mittels der Auswerteeinrichtung 44 eine Laufzeitmessung erfolgen, wobei die Zeit gemessen wird, die zwischen der Erzeugung des Schallsignals 58 mittels des Lautsprechers 60 bis zu einer Erfassung des Schallsignals 58 mittels des Gurtmikrofons 56 vergeht. Basierend auf der Laufzeitmessung ist die Auswerteeinrichtung 44 in der Lage, eine Distanz zu ermitteln, welche zwischen dem Lautsprecher 60 und dem Gurtmikrofon 56 liegt. Dadurch kann die Auswerteeinrichtung 44 bestimmen, ob der Sicherheitsgurt 12, insbesondere der Brustgurt, von dem Insassen 16 ordnungsgemäß genutzt ist. Ist auf dem Beckengurt 38 ebenfalls ein Gurtmikrofon 56 eingesetzt, ist die Auswerteeinrichtung 44 in der Lage, festzustellen, ob der Beckengurt 38 von dem Insassen 16 ordnungsgemäß genutzt ist.

Ferner kann bei der Vorrichtung 10 der Lautsprecher 60 derart gesteuert sein, dass das Schallsignal 58 zyklisch, das heißt zeitlich wiederkehrend, ausgesendet wird. Dadurch kann ein bestimmungsgemäßer Anlegestatus des Sicherheitsgurts 12 nicht nur einmal, zum Beispiel direkt nach einem Anschnallen, sondern über die gesamte Dauer, während welcher der Insasse 16 angegurtet sein soll, kontrolliert werden.

Ferner kann das Schallsignal 58 als ein Ultraschallsignal ausgebildet sein. Dadurch dass das menschliche Gehör Schallsignale im Ultraschallbereich nicht wahrnehmen kann, kann die Vorrichtung 10 in einem Kraftfahrzeug eingesetzt werden, ohne Komforteinbußen für den Insassen 16 in Kauf nehmen zu müssen. Ferner kann das als ein Ultraschallsignal ausgebildete Schallsignal 58 mittels des Lautsprechers 60 erzeugt werden, wobei der Lautsprecher 60 beispielsweise Teil einer Innenraumüberwachungseinrichtung einer Diebstahlwarnanlage des Kraftfahrzeugs sein kann. Es ist aber genauso denkbar, dass der Lautsprecher 60 Teil eines Infotainment-Systems des Fahrzeugs sein kann. Das Gurtmikrofon 56 ist auf den Frequenzbereich, in welchem der Lautsprecher 60 das Schallsignal 58 erzeugt, abgestimmt, sodass das Gurtmikrofon 56 das von dem Lautsprecher 60 erzeugte Schallsignal 58 erfassen kann.

Außerdem kann die Auswerteeinrichtung in der Lage sein, zumindest eine von das Schallsignal 58 charakterisierenden Größen zu ermitteln und basierend darauf festzustellen, ob der Insasse 16 den Sicherheitsgurt 12 bestimmungsgemäß angelegt hat. Eine das Schallsignal 58 charakterisierende Größe kann eine Amplitude oder eine Frequenz des Schallsignals 58 sein. Trifft das von dem Lautsprecher 60 erzeugte Schallsignal 58 auf ein Hindernis, kann bei dem Gurtmikrofon 56 ein Schallsignal ankommen, dass sich in seiner Amplitude und/oder seiner Frequenz von dem erzeugten Schallsignal 58 unterscheidet. Anders ausgedrückt, kann das Schallsignal 58 gedämpft und/oder gebeugt werden, bevor es mittels des Gurtmikrofons 56 erfasst wird. Die Auswerteeinrichtung 44 ist eingerichtet, anhand einer Beugung oder Dämpfung des Schallsignals 58 zu ermitteln, ob der Insasse 16 den Sicherheitsgurt 12 bestimmungsgemäß angelegt hat. Beispielsweise wird das Schallsignal 58 gedämpft, bevor es mittels des Gurtmikrofons 56 erfasst werden kann, wenn der Insasse 16 den Sicherheitsgurt 12, insbesondere den Brustgurt 26, hinter dem Rücken des Insassen 16, das heißt zwischen dem Insassen 16 und dem Fahrzeugsitz 24, hindurchführt. Alternativ oder zusätzlich kann das Schallsignal 58 gedämpft und/oder gebeugt sein, wenn der Insasse 16 den Beckengurt 38 direkt auf das Sitzkissen 22 des Fahrzeugsitzes 24 gelegt hat, wodurch der Insasse 16 auf dem Beckengurt 38 sitzt.

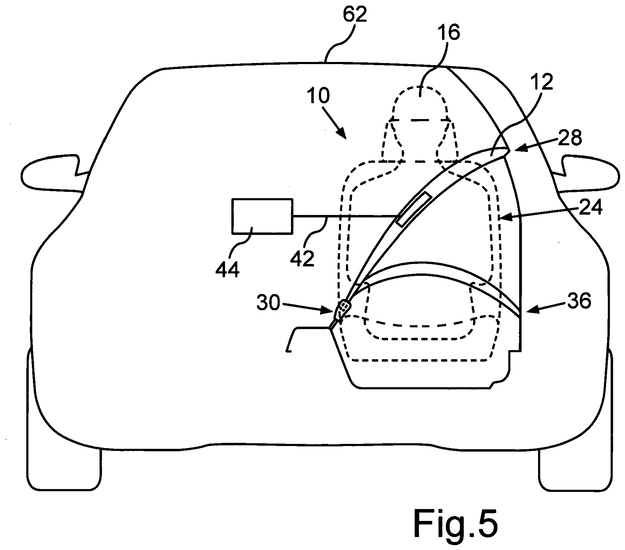

In Fig. 5 ist ein Kraftfahrzeug 62 dargestellt, welches eine Vorrichtung 10 zum Erkennen eines bestimmungsgemäßen Anlegestatus eines Sicherheitsgurts 12 einer Sicherheitsgurtvorrichtung umfasst.

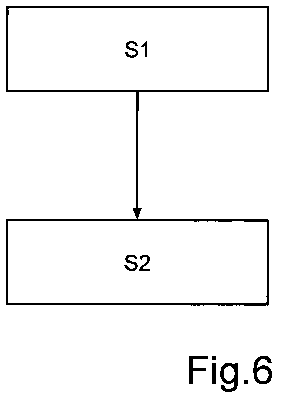

In Fig. 6 ist ein Verfahren gezeigt, mittels welchem ein Erkennen eines bestimmungsgemäßen Anlegestatus eines Sicherheitsgurts einer Sicherheitsgurtvorrichtung in einem Kraftfahrzeug erfolgt. Bei diesem Verfahren erfolgt in einem ersten Schritt S1 ein Ausgeben zumindest eines von der Anordnung des Sicherheitsgurts abhängigen Sensorwerts mittels einer zumindest teilweise in oder an dem Sicherheitsgurt angeordneten Sensoreinrichtung, und in einem zweiten Schritt S2 ein Ermitteln mittels einer Auswerteeinrichtung basierend auf dem ausgegebenen Sensorwert, ob ein Insasse des Kraftfahrzeugs den Sicherheitsgurt bestimmungsgemäß angelegt hat.

### Bezugszeichenliste:

- 10: Vorrichtung
- 12: Sicherheitsgurt
- 14: Sicherheitsgurtvorrichtung
- 16: Insasse
- 18: Kopfstütze
- 20: Rückenlehne
- 22: Sitzkissen
- 24: Fahrzeugsitz
- 26: Brustgurt
- 28: oberer äußerer Befestigungspunkt
- 30: innerer Befestigungspunkt
- 32: Gurtschloss
- 34: Gurtschlosszunge
- 36: unterer äußerer Befestigungspunkt
- 38: Beckengurt
- 40: Sensoreinrichtung
- 42: Übertragungseinheit
- 44: Auswerteeinrichtung
- 46: Elektrode
- 48: Elektrode bzw. Sitzheizungsmatte
- 50: Kabel
- 52: Elektrode
- 54: Elektrode bzw. Sitzheizungsmatte
- 56: Mikrofon
- 58: Schallsignal
- 60: Lautsprecher
- 62: Kraftfahrzeug

## Patentansprüche

1. Vorrichtung (10) zum Erkennen eines bestimmungsgemäßen Anlegestatus eines Sicherheitsgurts (12) einer Sicherheitsgurtvorrichtung (14) in einem Kraftfahrzeug (62), umfassend
- eine zumindest teilweise in oder an dem Sicherheitsgurt (12) angeordnete Sensoreinrichtung (40), welche dazu ausgelegt ist, wenigstens einen Sensorwert auszugeben, welcher eine Abhängigkeit von einer Anordnung des Sicherheitsgurts (12) aufweist; und
- eine Auswerteeinrichtung (44), welche dazu eingerichtet ist, basierend auf dem mittels der Sensoreinrichtung (40) ausgegebenen Sensorwert zu ermitteln, ob ein Insasse (16) des Kraftfahrzeugs (62) den Sicherheitsgurt (12) bestimmungsgemäß angelegt hat,
wobei die Sensoreinrichtung (40) zumindest ein an dem Sicherheitsgurt (12) angeordnetes Mikrofon (56) umfasst, welches dazu ausgelegt ist, ein mit zumindest einem erfassten Schallsignal (58) korrespondierendes Mikrofonsignal auszugeben, wobei die Auswerteeinrichtung (44) dazu eingerichtet ist, anhand des Mikrofonsignals zu ermitteln, ob der Insasse (16) den Sicherheitsgurt (12) bestimmungsgemäß angelegt hat, **dadurch gekennzeichnet, dass** wenigstens ein Lautsprecher (60) des Kraftfahrzeugs (62) das Schallsignal (58) erzeugt.

2. Vorrichtung (10) nach Anspruch 1,
**dadurch gekennzeichnet, dass**
die Sensoreinrichtung (40) einen Kondensator mit zwei Elektroden (46, 48, 52, 54) umfasst, wobei die eine Elektrode (46, 52) in oder an dem Sicherheitsgurt angeordnet und die andere Elektrode (58, 54) in Form einer Heizdrahtanordnung einer Sitzheizung ausgebildet ist, wobei die Auswerteeinrichtung (44) dazu eingerichtet ist, anhand eines am Kondensator gemessenen Zustandswerts zu ermitteln, ob der Insasse (16) den Sicherheitsgurt (12) bestimmungsgemäß angelegt hat.

3. Vorrichtung (10) nach Anspruch 1 oder 2,
**dadurch gekennzeichnet, dass**
das Schallsignal (58) ein Umgebungsgeräusch und/oder ein Geräusch des Kraftfahrzeugs (62) umfasst.

4. Vorrichtung (10) nach einem der vorhergehenden Ansprüche,
**dadurch gekennzeichnet, dass**
die Auswerteeinrichtung (44) dazu eingerichtet ist, anhand einer Messung der Laufzeit des Schallsignals (28) von dem Lautsprecher (60) zu dem Mikrofon (56) zu ermitteln, ob der Insasse (16) den Sicherheitsgurt (12) bestimmungsgemäß angelegt hat.

5. Vorrichtung (10) nach einem der vorhergehenden Ansprüche,
**dadurch gekennzeichnet, dass**
der Lautsprecher (60) eingerichtet ist, das Schallsignal (58) zyklisch auszusenden.

6. Vorrichtung (10) nach einem der vorhergehenden Ansprüche,
**dadurch gekennzeichnet, dass**
der Lautsprecher (60) eingerichtet ist, das Schallsignal (58) als ein Ultraschallsignal auszusenden.

7. Vorrichtung (10) nach einem der vorhergehenden Ansprüche,
**dadurch gekennzeichnet, dass**
die Auswerteeinrichtung (44) dazu eingerichtet ist, anhand zumindest einer Veränderung einer das Schallsignal (58) charakterisierenden Größe zu ermitteln, ob der Insasse (16) den Sicherheitsgurt (12) bestimmungsgemäß angelegt hat.

8. Kraftfahrzeug (62) mit einer Vorrichtung (10) zum Erkennen eines bestimmungsgemäßen Anlegestatus eines Sicherheitsgurts (12) einer Sicherheitsgurtvorrichtung (14) nach einem der vorhergehenden Ansprüche.

9. Verfahren zum Erkennen eines bestimmungsgemäßen Anlegestatus eines Sicherheitsgurts (12) einer Sicherheitsgurtvorrichtung (14) in einem Kraftfahrzeug (62), mit den Schritten:
- Ausgeben zumindest eines von der Anordnung des Sicherheitsgurts (12) abhängigen Sensorwertes mittels einer zumindest teilweise in oder an dem Sicherheitsgurt (12) angeordneten Sensoreinrichtung (40); und
- Ermitteln mittels einer Auswerteeinrichtung (44) basierend auf dem ausgegebenen Sensorwert, ob ein Insasse (16) des Kraftfahrzeugs (62) den Sicherheitsgurt (12) bestimmungsgemäß angelegt hat,
wobei die Sensoreinrichtung (40) zumindest ein an dem Sicherheitsgurt (12) angeordnetes Mikrofon (56) umfasst, mittels dessen ein mit zumindest einem erfassten Schallsignal (58) korrespondierendes Mikrofonsignal ausgegeben wird, wobei mittels der Auswerteeinrichtung (44) anhand des Mikrofonsignals ermittelt wird, ob der Insasse (16) den Sicherheitsgurt (12) bestimmungsgemäß angelegt hat, **dadurch gekennzeichnet, dass** wenigstens ein Lautsprecher (60) des Kraftfahrzeugs (64) das Schallsignal (58) erzeugt.

## Claims

1. Device (10) for identifying a proper belt usage status of a seat belt (12) of a seat belt device (14) in a motor vehicle, comprising
- a sensor device (40) which is at least partially arranged in or on the seat belt (12) and is configured to output at least one sensor value which depends on an arrangement of the seat belt (12); and
- an evaluation device (44) which is designed to determine on the basis of the sensor value output by means of the sensor device (40) whether an occupant (16) of the motor vehicle has fastened the seat belt (12) properly,
wherein
the sensor device (40) comprises at least one microphone (56) which is arranged on the seat belt (12) and is designed to output a microphone signal corresponding to at least one recorded sound signal (58), wherein the evaluation device (44) is configured to determine on the basis of the microphone signal whether the occupant (16) has fastened the seat belt (12) properly, **characterised in that** at least one loudspeaker (60) of the motor vehicle (62) generates the sound signal (58).

2. Device (10) according to claim 1,
**characterised in that**
the sensor device (40) comprises a capacitor with two electrodes (46, 48, 52, 54), one electrode (46, 52) being arranged in or on the seat belt and the another electrode (58, 54) being designed in the form of a heating wire arrangement of a seat heater, the evaluation device (44) being configured to determine on the basis of a state value measured on the capacitor whether the occupant (16) has fastened the seat belt (12) properly.

3. Device (10) according to claim 1 or 2,
**characterised in that**
the sound signal (58) comprises an ambient noise and/or a noise of the motor vehicle (62).

4. Device (10) according to any of the preceding claims,
**characterised in that**
the evaluation device (44) is configured to determine on the basis of a measurement of the propagation time of the sound signal (28) from the loudspeaker (60) to the microphone (56) whether the occupant (16) has fastened the seat belt (12) properly.

5. Device (10) according to any of the preceding claims,
**characterised in that**
the loudspeaker (60) is configured to transmit the sound signal (58) cyclically.

6. Device (10) according to any of the preceding claims,
**characterised in that**
the loudspeaker (60) is configured to transmit the sound signal (58) as an ultrasound signal.

7. Device (10) according to any of the preceding claims,
**characterised in that**
the evaluation device (44) is configured to determine on the basis of at least one change in a variable characterising the sound signal (58) whether the occupant (16) has fastened the seat belt (12) properly.

8. Motor vehicle having a device (10) for identifying a proper belt usage status of a seat belt (12) of a seat belt device (14) according to any of the preceding claims.

9. Method for identifying a proper belt usage status of a seat belt (12) of a seat belt device (14) in a motor vehicle (62), having the following steps :
- outputting at least one sensor value which depends on the arrangement of the seat belt (12) by means of a sensor device (40) which is at least partially arranged in or on the seat belt (12); and
- determining, by means of an evaluation device (44) on the basis of the output signal value, whether an occupant (16) of the motor vehicle (62) has fastened the seat belt (12) properly,
wherein
the sensor device (40) comprises at least one microphone (56) which is arranged on the seat belt (12), by means of which microphone a microphone signal corresponding to at least one recorded sound signal (58) is output, wherein it is determined by means of the evaluation device (44) on the basis of the microphone signal whether the occupant (16) has fastened the seat belt (12) properly, **characterised in that** at least one loudspeaker (60) of the motor vehicle (64) generates the sound signal (58).

## Revendications

1. Dispositif (10) pour détecter un état de mise en place correct d'une ceinture de sécurité (12) d'un dispositif à ceinture de sécurité (14) dans un véhicule automobile (62), comprenant
- un dispositif de détection (40) disposé au moins partiellement dans ou sur la ceinture de sécurité (12), lequel dispositif de détection est conçu pour fournir au moins une valeur de détection, laquelle présente une sujétion à un agencement de la ceinture de sécurité (12) ; et
- un dispositif d'évaluation (44), lequel est conçu pour déterminer, sur la base de la valeur de détection fournie au moyen du dispositif de détection (40), si un occupant (16) du véhicule automobile (62) a mis la ceinture de sécurité (12) en place correctement,
le dispositif de détection (40) comprenant au moins un microphone (56) disposé sur la ceinture de sécurité (12), qui est conçu pour délivrer un signal de microphone correspondant à au moins un signal sonore (58) détecté, le dispositif d'évaluation (44) étant conçu pour déterminer, sur la base du signal de microphone, si l'occupant (16) a mis la ceinture de sécurité (12) en place correctement, **caractérisé en ce qu'**au moins un haut-parleur (60) du véhicule automobile (62) génère le signal sonore (58).

2. Dispositif (10) selon la revendication 1,
**caractérisé en ce que**
le dispositif de détection (40) comprend un condensateur avec deux électrodes (46, 48, 52, 54), l'une électrode (46, 52) étant disposée dans ou sur la ceinture de sécurité et l'autre électrode (58, 54) étant conçue sous la forme d'un agencement de fil chauffant d'un chauffage de siège, le dispositif d'évaluation (44) étant conçu pour déterminer, sur la base d'une valeur d'état mesurée au niveau du condensateur, si l'occupant (16) a mis la ceinture de sécurité (12) en place correctement.

3. Dispositif (10) selon la revendication 1 ou 2,
**caractérisé en ce que**
le signal sonore (58) comprend un bruit ambiant et/ou un bruit du véhicule automobile (62).

4. Dispositif (10) selon l'une quelconque des revendications précédentes,
**caractérisé en ce que**
le dispositif d'évaluation (44) est configuré pour déterminer, sur la base d'une mesure du temps de transit du signal sonore (28) du haut-parleur (60) au microphone (56), si l'occupant (16) a mis la ceinture de sécurité (12) en place correctement.

5. Dispositif (10) selon l'une quelconque des revendications précédentes,
**caractérisé en ce que**
le haut-parleur (60) est configuré pour transmettre le signal sonore (58) de manière cyclique.

6. Dispositif (10) selon l'une quelconque des revendications précédentes,
**caractérisé en ce que**
le haut-parleur (60) est configuré pour émettre le signal sonore (58) sous forme de signal ultrasonore.

7. Dispositif (10) selon l'une quelconque des revendications précédentes,
**caractérisé en ce que**
le dispositif d'évaluation (44) est configuré pour déterminer, sur la base d'au moins une modification d'une variable caractérisant le signal sonore (58), si l'occupant (16) a mis la ceinture de sécurité (12) en place correctement.

8. Véhicule automobile (62) avec un dispositif (10) pour détecter un état de mise en place correct d'une ceinture de sécurité (12) d'un dispositif à ceinture de sécurité (14) selon l'une quelconque des revendications précédentes.

9. Procédé pour détecter un état de mise en place correct d'une ceinture de sécurité (12) d'un dispositif à ceinture de sécurité (14) dans un véhicule automobile (62), comprenant les étapes consistant à :
- fournir au moins une valeur de détection dépendant de la disposition de la ceinture de sécurité (12) au moyen d'un dispositif de détection (40) disposé au moins partiellement dans ou sur la ceinture de sécurité (12) ; et
- déterminer au moyen d'un dispositif d'évaluation (44) sur la base de la valeur de détection fournie si un occupant (16) du véhicule automobile (62) a mis la ceinture de sécurité (12) en place correctement,
le dispositif de détection (40) comprenant au moins un microphone (56) disposé sur la ceinture de sécurité (12), par lequel est émis un signal de microphone correspondant à au moins un signal sonore (58) détecté, le dispositif d'évaluation (44) déterminant à l'aide du signal de microphone si l'occupant (16) a mis la ceinture de sécurité (12) en place correctement, **caractérisé en ce qu'**au moins un haut-parleur (60) du véhicule automobile (64) génère le signal sonore (58).
